# NOUVEAU FASCICULE DE BREVET EUROPEEN

(11) **EP 0 333 551 B2**
(45) Date de publication et mention de la décision concernant l'opposition: **18.08.1999**
(45) Mention de la délivrance du brevet: 07.01.1993
(21) Numéro de dépôt: 89400608.9
(22) Date de dépôt: 03.03.1989
(51) Int. Cl.: H03J 7/18

(54) **Appareil de radio avec système de recherche de canal d'émission**
Rundfunkgerät mit einer Sendekanal suchenden Anordnung
Radio apparatus with a transmission channel searching system

(30) Priorité: 08.03.1988 FR 8802914
(43) Date de publication de la demande: 20.09.1989
(73) Titulaire: STMicroelectronics S.A., 94250 Gentilly (FR)
(72) Inventeur: Brisson, Pierre, F-75116 Paris (FR)
(74) Mandataire: Ballot, Paul Denis Jacques

(56) Documents cités:
- EP-A- 0 155 728
- DE-A- 2 445 520
- DE-A- 3 040 465
- DE-A- 3 148 085
- DE-A- 3 149 409
- DE-C- 2 755 596
- Funkschau, 1985, numéro 21, pages 39 et 40
- Funkschau, 1986, numéro 5, pages 32 et 33
- Extrait du mode d'emploi de l'autoradio de la firme Blaupunkt avec la désignation "Berlin IQR 85 et nomination d'un témoin
- Funkschau, 1986, numéro 13, pages 24-28.

## Description

La présente invention concerne les appareils de radio et plus particulièrement ceux que l'on nomme autoradios parce qu'ils sont montés dans les véhicules pour permettre d'écouter des émissions de radio pendant que l'on se déplace d'un lieu à un autre.

L'invention pourrait aussi concerner, par extension, des appareils de télévision pouvant être installés dans des autocars ou des trains pour être mis à la disposition des voyageurs pendant leur trajet.

Un problème qui se pose avec les autoradios lorsqu'on se déplace sur un grand trajet est le fait que l'on ne connaît pas les fréquences auxquelles sont émises localement les émissions qui sont produites à une échelle nationale.

Ainsi par exemple un automobiliste qui part de Paris en écoutant une émission de radio nationale émise sur une fréquence F1 va recevoir correctement cette émission pendant une partie de son trajet, par exemple pendant une centaine de kilomètres; puis il va la recevoir de moins en moins bien, et enfin plus du tout.

Mais il pourrait continuer à la recevoir correctement s'il changeait au moment opportun la fréquence de réception de son appareil, car lorsqu'il se trouve dans une région autre que la région parisienne, le programme est réémis par un réémetteur local sur une fréquence différente, chaque fréquence correspondant à une région déterminée centrée sur ce réémetteur.

L'invention propose un système particulièrement pratique pour que l'utilisateur qui veut écouter un même programme pendant un déplacement à longue distance n'ait pas à se préoccuper de la recherche de la fréquence d'émission des réémetteurs successifs au voisinage desquels il se déplace au cours de son trajet.

Le système selon l'invention comporte une carte à mémoire ou "carte à puce" contenant une série d'informations stockées de manière permanente, chaque information correspondant à une fréquence de réémission de l'un des réémetteurs du programme choisi. La carte à mémoire est donc spécifique de ce programme, c'est-à-dire spécifique d'une station de radio déterminée émettant ce programme sur un territoire plus vaste que la portée d'un seul émetteur et émettant donc à travers plusieurs réemetteurs fonctionnant à des fréquences différentes. La carte à mémoire est associée à un lecteur de carte qui coopère avec l'appareil radio pour accorder la fréquence de réception de celui-ci à chaque instant sur l'une des fréquences correspondant aux informations stockées dans la carte (et pas sur une fréquence autre), et plus précisément sur celle qui correspond à la plus forte puissance reçue à cet instant. Des moyens sont prévus dans l'appareil pour accorder la fréquence de réception sur la fréquence dont la puissance est la plus forte, et des moyens sont prévus pour modifier la fréquence d'accord de l'appareil lorsqu'une autre fréquence prend le pas en puissance sur la fréquence sur laquelle l'appareil état précédemment accordé.

Ainsi, si par exemple la carte a en mémoire 12 fréquences correspondant aux différentes fréquences de réémission d'une station sur le territoire français, l'appareil de radio reste accordé à chaque instant sur la fréquence correspondant à la plus forte puissance reçue parmi ces douze fréquences.

En pratique les responsables d'une station de radio pourront distribuer des cartes correspondant à leurs fréquences d'émission et de réémission. L'utilisateur n'aura qu'à insérer dans le lecteur associé à son appareil la carte correspondant à la station de radio qu'il désire écouter tout au long de son trajet.

Pour la réalisation de l'invention, on prévoit de préférence que c'est le lecteur de cartes qui va comparer les puissances reçues sur les différents canaux. Par exemple, le lecteur de cartes sera pourvu d'un microprocesseur assurant un balayage des différentes fréquences enregistrées dans la carte; au-trement dit, le microprocesseur va commander un circuit de réception prévu dans le lecteur de cartes; ce circuit sera successivement accordé sur les différentes fréquences enregistrées, sous la commande du microprocesseur qui va chercher dans la carte les différentes fréquences qu'y a mises l'utilisateur. Les puissances reçues pour chaque fréquence seront mesurées et comparées entre elles. La fréquence pour laquelle le signal reçu est le plus élevé sera sélectionnée.

Le cyde de balayage de fréquence comporte donc plusieurs étapes consistant chacune en un accord sur une fréquence bien déterminée puis une mesure de puissance et diverses opérations.

Pour chaque étape, c'est-à-dire pour chaque fréquence d'accord, le circuit de réception accordé sur cette fréquence va fournir un signal de sortie dont la puissance moyenne peut être mesurée; la mesure de puissance peut être convertie par exemple en un signal numérique stocké dans une mémoire dans un premier registre. La valeur stockée dans le premier registre est comparée à une valeur stockée dans un deuxième registre. Ce deuxième registre contient la mesure de puissance effectuée à l'étape précédente, c'est-à-dire pour la fréquence précédente indiquée par le microprocesseur.

Selon le résultat de la comparaison, on effectue différentes opérations; si la valeur stockée dans le premier registre est inférieure à la valeur stockée dans le deuxième (c'est-à-dire si elle représente une puissance inférieure), on passe directement à l'étape suivante, c'est-à-dire que le microprocesseur indique une autre fréquence d'accord; si au contraire la valeur stockée dans le premier registre est supérieure à la valeur stockée dans le deuxième registre, le microprocesseur remplace le contenu du deuxième registre par le contenu du premier et inscrit dans un troisième registre une indication de la fréquence d'accord correspondante; puis le microprocesseur passe à une étape suivante et fournit une autre fréquence d'accord.

Lorsque toutes les fréquences d'accord enregistrées dans la carte ont été balayées, on trouve dans le deuxième registre la puissance la plus élevée enregistrée au cours du cycle de balayage et dans le troisième registre une indication de la fréquence correspondant à la puissance reçue la plus forte. Le contenu du deuxième registre sera remis à zéro avant de commencer un nouveau cycle.

Le microprocesseur compare alors l'indication de fréquence contenue dans le troisième registre à une indication de fréquence contenue dans un quatrième registre; le quatrième registre contient la fréquence pour laquelle l'appareil de radio est en train de fonctionner pour l'utilisateur.

Selon le résultat de la comparaison, le microprocesseur effectue des opérations différentes.

Si le résultat de la comparaison indique que les indications de fréquence contenues dans les troisième et quatrième registres sont identiques, il recommence un nouveau cycle de balayage (après avoir remis à zéro comme on l'a dit le deuxième registre).

Si au contraire le résultat de la comparaison montre une différence entre les contenus des troisième et quatrième registre, le microprocesseur remplace le contenu du quatrième registre par le contenu du troisième et fournit par ailleurs un signal indiquant qu'il y a lieu de refaire l'accord de l'appareil de radio. Ce signal est transmis à l'appareil de radio, ainsi que le contenu du quatrième registre, et l'apparel de radio s'accorde alors automatiquement sur la fréquence correspondant au contenu de ce registre.

Ensuite, là encore, un nouveau cycle de balayage est initié par le microprocesseur après remise à zéro du deuxième registre.

C'est ainsi que cycliquement on vérifie que la puissance moyenne reçue est bien la plus forte pour la fréquence qui est justement reçue (celle qui correspond au contenu du quatrième registre); et si d'aven ture on s'aperçoit au cours d'un cycle que la puissance reçue est plus forte pour une autre fréquence parmi les fréquences préenregistrées, alors on bascule l'accord de l'appareil radio sur cette autre fréquence.

On peut effectuer la mesure de puissance soit de manière absolue soit de manière relative par rapport au niveau de bruit reçu, soit encore à la fois de manière relative et de manière absolue.

D'autre part, on peut très bien imaginer que la recherche d'accord par balayage de fréquence n'est pas effectuée systématiquement mais seulement si le niveau de puissance reçu n'est plus suffisant: par exemple on peut mesurer le rapport signal sur bruit moyen pour la fréquence sur laquelle l'appareil de radio est accordé à un moment donné et maintenir systématiquement l'accord sur cette fréquence dès lors que le rapport signal/bruit est supérieur à un seuil prédéterminé; si le rapport signal /bruit est inférieur à ce seuil on peut effectuer le cycle de balayage décrit plus haut, ou alors on peut vérifier que le niveau de puissance moyen est dans l'absolu supérieur un seuil et, seulement s'il ne l'est pas, on procède au balayage de fréquence décrit ci-dessus.

## Revendications

1. Appareil de radio pour véhicule, caractérisé en ce qu'il comporte un lecteur de cartes à mémoire apte à recevoir une carte contenant une série d'informations stockées de manière permanente, chaque information représentant une fréquence de réémission de l'un des réémetteurs d'un programme de radio choisi, la carte à mémoire étant spécifique d'un seul programme, l'appareil comprenant en outre des moyens pour déterminer quelle est celle, parmi ces fréquences, qui est reçue avec le plus de puissance, et des moyens pour accorder l'appareil radio sur cette fréquence et pour modifier l'accord lorsque la puissance devient plus élevée sur une autre fréquence parmi les fréquences stockées en mémoire.

## Patentansprüche

1. Rundfunkgerät für ein Fahrzeug, gekennzeichnet durch einen Speicherkartenleser, der eine eine Reihe von dauerhaft gespeicherten Informationen enthaltende Karte aufnehmen kann, wobei jede Information eine Sendefrequenz eines der Relaissender eines gewählten Radioprogramms repräsentiert, wobei die Speicherkarte für ein einziges Programm gilt, ferner durch Mittel zum Bestimmen, welche unter den Frequenzen, die mit der größten Leistung empfangene Frequenz ist, und Mittel zum Abstimmen des Rundfunkgeräts auf diese Frequenz und zum Ändern der Abstimmung, wenn die Leistung auf einer anderen Frequenz unter den im Speicher gespeicherten Frequenzen höher wird.

## Claims

1. Radio apparatus for a vehicle, characterized in that it comprises a memory card reader adapted to receive a card containing a set of permanently stored data, each data item representing a re-transmission frequency of one of the re-transmitters of a chosen radio programme, the memory card being specific for a single programme, the apparatus also comprising means for determining which of the said frequencies is received with the greatest strength and means for tuning the radio apparatus to this frequency and for changing the tuning when a different frequency among the frequencies stored in memory becomes stronger.
